# EUROPEAN PATENT APPLICATION

(11) **EP 4 822 740 A1**
(43) Date of publication of application: **14.10.2026**
(21) Application number: 25169892.4
(22) Date of filing: 10.04.2025
(51) Int. Cl.: H01L 21/683

(54) **REMOVAL OF WAFER REGIONS**

(71) Applicant: NXP B.V., 5656 AG Eindhoven (NL)
(72) Inventor: ZENZ, Christian, 8010 Graz (AT); EIPER, Ernst, 8010 Graz (AT); CECCARELLI, David, 8113 Eisbach (AT); COBUSSEN, Johannes, 6641KH Beuningen (NL)
(74) Representative: Colaiuda, Antonella

(57) **Abstract**

A method comprising, providing a plurality of first semiconductor dies on a surface of a carrier in a first region. Providing a second semiconductor die on the carrier in a second region. Etching a trench between each of the semiconductor dies, each trench extends into the carrier to a depth. Mounting a grinding foil on the carrier to attach each semiconductor die to the grinding foil. Back grinding a surface of the carrier to the depth. Applying a carrier foil to the back-grinded surface of the carrier. Either modifying the grinding foil or the carrier foil in a region aligned with the first region or use a de-taping module to press the grinding foil to the carrier foil. Then releasing, the plurality of first semiconductor dies from the grinding foil. The plurality of first semiconductor dies release from the grinding foil on removal of the grinding foil from the carrier.

## Description

### FIELD

The present disclosure relates to methods for removing regions from a semiconductor wafer,

### BACKGROUND

Separation of wafers into single Semiconductor dies is typically done by means of blade dicing. This requires a so called saw lane with a minimum width between the dies to allow for the dicing process. For processing the wafers in the wafer fab, required process control monitor structures (PCM) and optical control modules (OCM) are placed in the saw lane. For smaller die sizes the ratio between saw lane width and die size is increasing and thus reducing the total amount of ICs per wafer. Therefore, it is preferred to reduce the saw lane width to a minimum. As the PCM/OCMs cannot longer be placed in the saw lane due to size constraints, PCM/OCMs need to be placed in the reticle field instead of a functional die. For PCM/OCM structures that are longer than the actual die size, these structures will extend in to saw lane.

State of the art dicing processes for very small saw lanes (typically < 50µm), e.g. Laser stealth dicing or plasma dicing allow for saw lane width as low as e.g. 7µm but require a saw lane without any metal structures as PCM/OCMs.

### SUMMARY

Aspects of the present disclosure are set out in the accompanying independent and dependent claims. Combinations of features from the dependent claims may be combined with features of the independent claims as appropriate and not merely as explicitly set out in the claims.

According to an aspect, there is provided a method, comprising:
providing a plurality of first semiconductor dies on a first major surface of a carrier in a first region;
providing a second semiconductor die on said first major surface of the carrier in a second region;
etching a trench between each of the semiconductor dies, wherein each trench extends down into said first major surface of the carrier to a trench depth;
mounting a grinding foil on said first major surface of the carrier to attach each semiconductor die to the grinding foil;
back grinding a second major surface of the carrier opposite said first major surface of the carrier at least to the trench depth;
applying a carrier foil to the back-grinded second major surface of the carrier; and
   either:
   modifying the grinding foil in a region of the grinding foil aligned with the first region of the carrier;
      or
   modifying the carrier foil in a region of the carrier foil aligned with the first region of the carrier;
wherein said modification of the grinding foil or the carrier foil causes the plurality of first semiconductor dies to release from the grinding foil on removal of the grinding foil from the first major surface of the carrier, wherein the second semiconductor die remains on the grinding foil.

According to an embodiment, the method further comprises modifying both the carrier foil and the grinding foil aligned with the first region of the carrier.

In one embodiment, the modifying step is configured to:
locally decrease the adhesion of the grinding foil in the first region of the carrier, and/or
locally increase the adhesion of the carrier foil in the first region of the carrier.

In one embodiment, the modifying step comprises, illuminating a foil in the first region, wherein the foil is illuminated with UV light that ranges from 100nm to 400nm.

In one embodiment, the method comprises using a mask during said illumination of the foil in the first region to mask the second region from the UV light.

According to an embodiment, the modifying step comprises, applying an additional adhesion layer to the foil, wherein the additional adhesion layer comprises an adhesion promoting or inhibiting material.

In one embodiment, the modifying step comprises, applying a local surface treatment using a laser.

In one embodiment, the modifying step further comprises, modifying a major surface of the second semiconductor die, wherein the modification comprises a dedicated bump structure for increasing the surface area of the major surface, or a local topography modification, to increase the adhesion of the grinding foil to the second semiconductor die.

In one embodiment, the second semiconductor die comprises a process control monitor, PCM.

According to another aspect, there is provided a method, comprising:
providing a plurality of first semiconductor dies on a first major surface of a carrier in a first region;
providing a second semiconductor die on said first major surface of the carrier in a second region;
etching a trench between each of the semiconductor dies, wherein each trench extends down into said first major surface of the carrier to a trench depth;
mounting a grinding foil on said first major surface of the carrier to attach each semiconductor die to the grinding foil;
back grinding a second major surface of the carrier opposite said first major surface of the carrier at least to the trench depth;
using a de-taping module to press a carrier foil to the back-grinded second major surface of the carrier; and
removing the grinding foil from the first major surface of the carrier, to release the plurality of first semiconductor dies from the grinding foil,
wherein said de-taping module applies pressure to the grinding foil in said second region of the carrier to cause the second semiconductor die to remain on the grinding foil on removal of the grinding foil from the first major surface of the carrier.

In one embodiment, the de-taping module comprises a template stamp to apply pressure to the carrier foil and the grinding foil.

According to an embodiment, the template stamp comprises a shape that corresponds to the second region, wherein the shape of the template stamp has a topography to increase the pressure in the second region.

In one embodiment, the topography of the template stamp comprises an embossed part and a corresponding debossed part, located opposite the embossed part.

In one embodiment, the topography of the template stamp comprises two mutually opposed embossed parts.

According to an embodiment, the second semiconductor die is a process control monitor, PCM.

### BRIEF DESCRIPTION OF DRAWINGS

Embodiments of this disclosure will be described hereinafter, by way of example only, with reference to the accompanying drawings in which like reference signs relate to like elements and in which:
Figures 1A - 1F show the method steps, according to a first embodiment;
Figures 1G(i) - 1G(ii) show other views of method step 302 of Figure 1C;
Figure 2 shows a flow chart of the method steps, according to the first embodiment;
Figures 3A - 3B show the method steps, according to a second embodiment;
Figures 3C(i) - 3C(ii) show other views of template stamp 1008/1010; and
Figure 4 shows a flow chart of the method steps, according to the second embodiment.

### DETAILED DESCRIPTION

Embodiments of the present disclosure are described in the following with reference to the accompanying drawings.

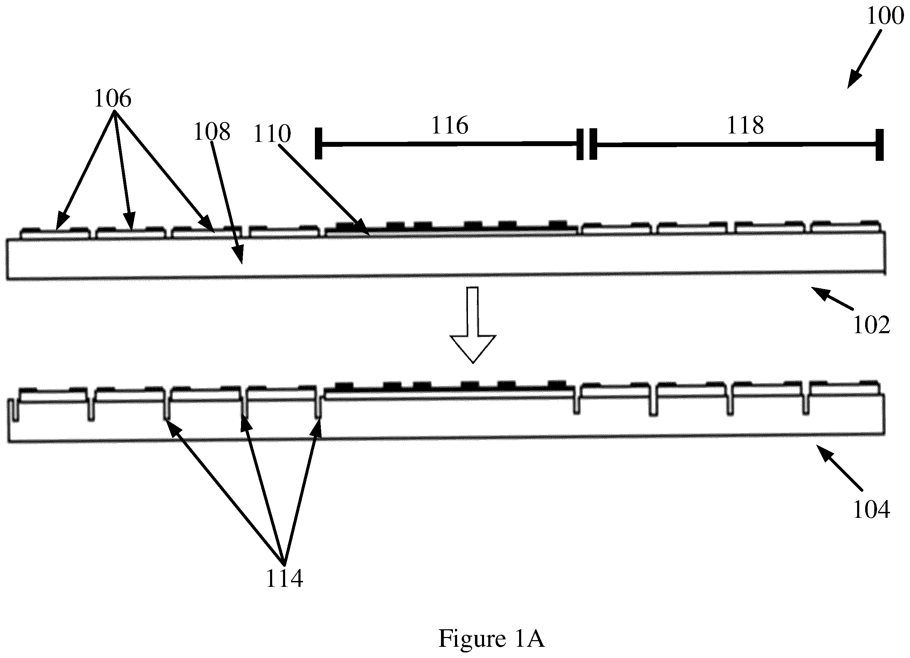

Figure 1A illustrates a first set of method steps 100 including a first step 102 and a second step 104, in accordance with a first embodiment. The first step 102 includes providing a carrier 108, which includes a first major surface and a second major surface. The second major surface of the carrier 108 is opposite the first major surface of the carrier 108. In the present example, the carrier 108 may be a silicon base substrate. On the first major surface of the carrier 108 there is provided a plurality of first semiconductor dies 106 in a first region 118. There may be a plurality of first regions 118 across the first major surface of the carrier 108. On the first major surface of the carrier 108 there is further provided a second semiconductor die 110 in a second region 116. The second semiconductor die 110 may be a Process Control Monitor (PCM) or Optical Control Monitor (OCM) that may be larger than each of the plurality of first semiconductor dies 106.

As shown in Figure 1A, the first set of methods steps 100 further includes the second step 104, in accordance with the first embodiment. The second step 104 includes etching a trench 114 or series of trenches between each of the semiconductor dies 106, 110. The semiconductor dies include the plurality of first semiconductor dies 106 and the second semiconductor die 110. Each trench 114 extends down into the first major surface of the carrier108 to a trench depth. The trench depth may be between 10 to 300 µm and each trench 114 may be etched using, for example an oxide etch process and, or a Bosch process.

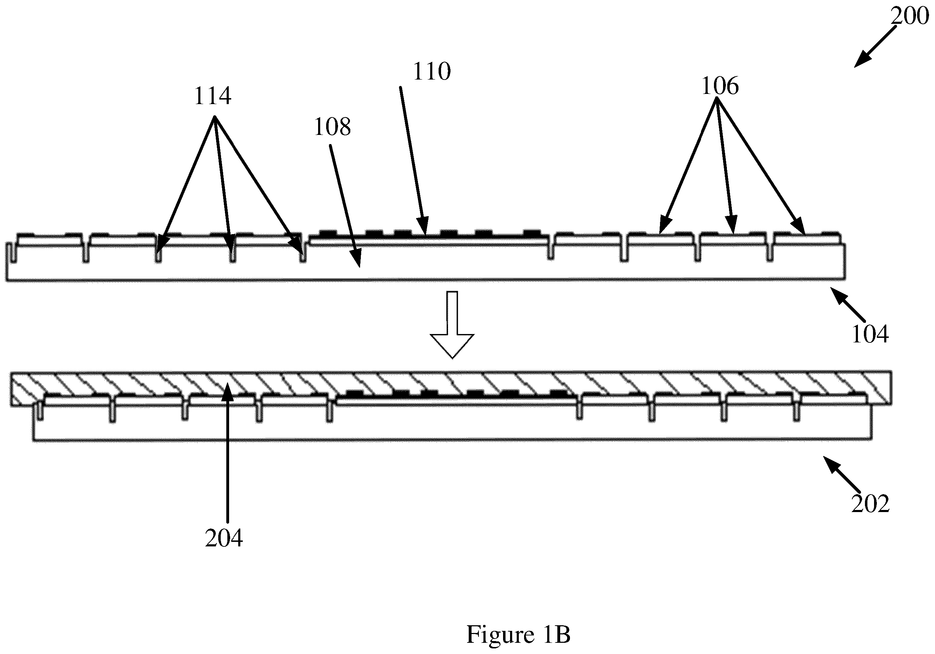

Figure 1B illustrates a second set of method steps 200 including the second step 104 of Figure 1A and a third step 202. The third step 202 includes mounting a grinding foil 204 on the first major surface of the carrier 108, thereby also attaching the grinding foil 204 to the plurality of first semiconductor dies 106 and the second semiconductor die 110. The grinding foil 204 may be mounted onto the carrier 108 using tape lamination or rolling. The function of mounting the grinding foil 204 may be to protect the plurality of first semiconductor dies 106 and the second semiconductor die 110 from mechanical damage during the forthcoming back grinding process and to make sure the semiconductor dies 106/110 stay in position across the carrier 108.

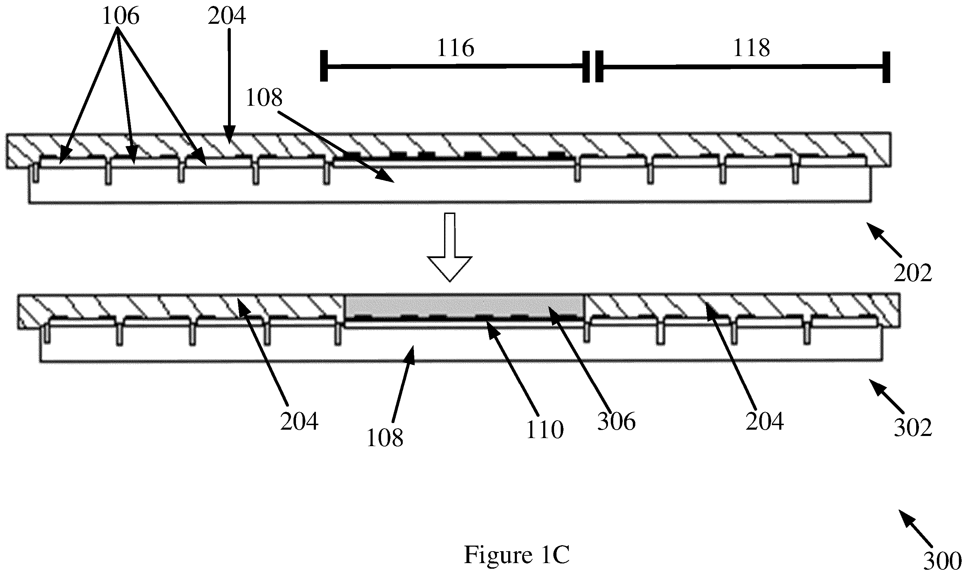

Figure 1C illustrates a third set of method steps 300 including the third step 202 of Figure 1B and a fourth step 302. The fourth step 302 includes modifying the grinding foil 204 in the first region 118. Modifying the grinding foil 204 in the first region 118 may include illuminating the foil with UV light. The UV light may have a wavelength range of 100nm to 400nm. The function of illuminating the first region 118 with UV light may be to locally initiate a cross-linking of the grinding foil 204. This may result in decreased local adhesion between the first region 118 of the grinding foil 204 and the plurality of first semiconductor dies 106. The modification may be performed using a localised laser that illuminates the first region 118 with UV light. By this procedure the second semiconductor die 110 in the second region 116 may adhere to the grinding foil 204 and the plurality of first semiconductor dies 106 in the first region 118 may adhere to the carrier 108. The second semiconductor die 110 in the second region 116 may be removed together with the grinding foil 204.

Figure 1C further illustrates the region 306 of the grinding foil 204 which may be masked. Therefore, when the grinding foil 204 is illuminated with UV light, the region 306 of the grinding foil 204 that is aligned with the second region 116 may not be illuminated with UV light. This may result in the adhesion between the grinding foil 204 in the second region 116 and the second semiconductor die 110 being increased relative to the adhesion between the grinding foil 204 in the first region 118 and the plurality of first semiconductor dies 106.

In the present embodiment, modifying the grinding foil 204 may alternatively include, applying an additional adhesion layer to the first major surface of the carrier 108. Applying the additional adhesion layer may include mounting the additional adhesion layer in the second region 116 of the carrier 108, prior to mounting the grinding foil 204 on the first major surface of the carrier 108. The function of applying an additional adhesion layer may be to promote adhesion between the region 306 of the grinding foil 204 and the second semiconductor die 110. The additional adhesion layer may include an adhesion promoting or inhibiting material.

In this embodiment, modifying the grinding foil 204 in the first region 118 may also alternatively include, applying a local surface treatment to the grinding foil 204 in the first region 118, using a laser.

In the present embodiment, modifying the grinding foil 204 may also alternatively include, modifying a major surface of the grinding foil 204 and/or the second semiconductor die 110, wherein the modification includes providing a dedicated bump structure for increasing the surface area of the major surface, or for increasing the local topography.

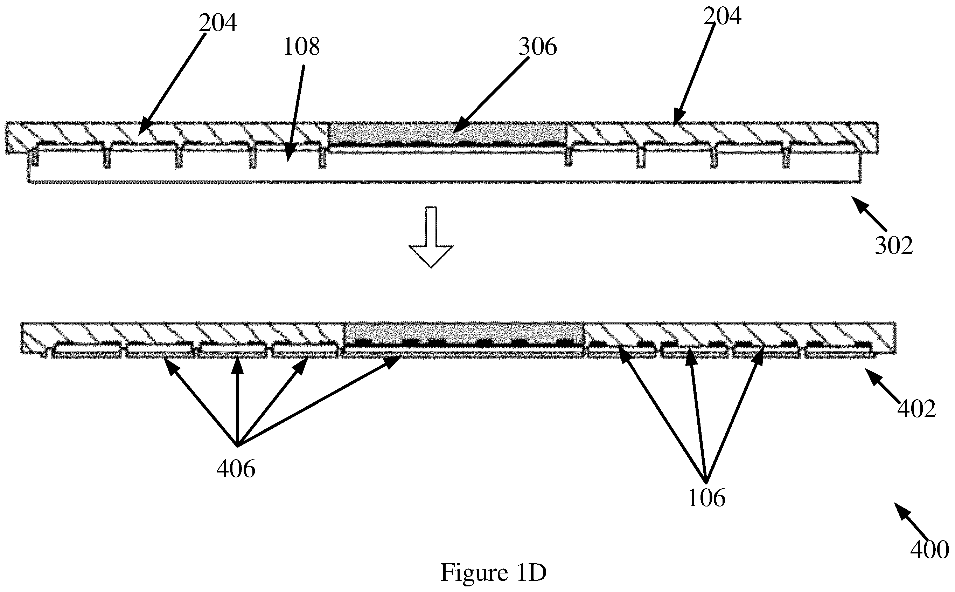

Figure 1D illustrates a fourth set of method steps 400 including the fourth step 302 of Figure 1C and a fifth step 402. The fifth step 402 includes back grinding the second major surface of the carrier 108 to the trench depth. The plurality of first semiconductor dies 106 and the second semiconductor die 110 remain attached to the grinding foil 204 in the same position. Back grinding the carrier 108 may singulate each of the first semiconductor dies 106 and the second semiconductor die 110 from one another. There may be a small vestigial layer of the carrier 406 that remains attached to each of the plurality of first semiconductor dies 106 and the second semiconductor die 110.

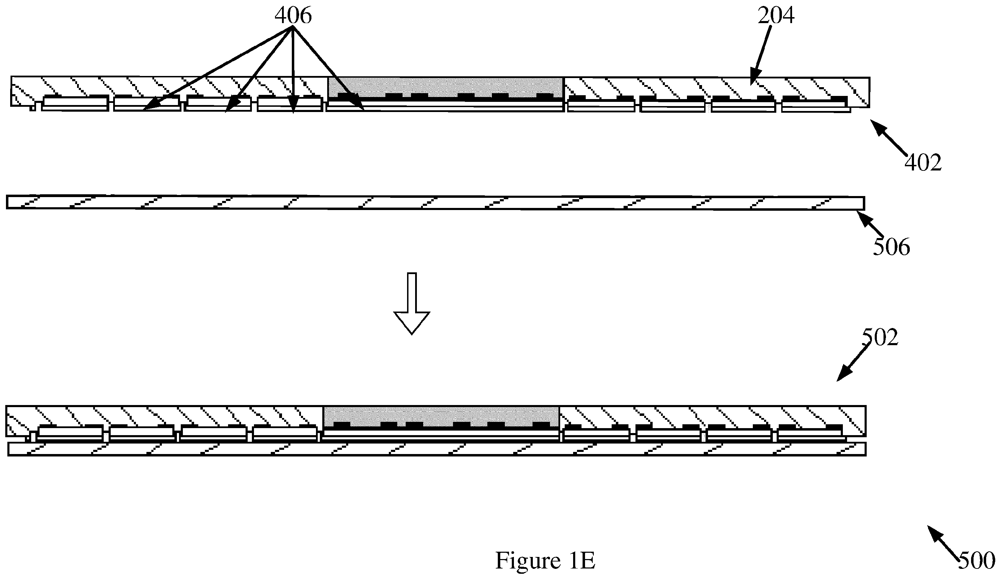

Figure 1E illustrates a fifth set of method steps 500 including the fifth step 402 of Figure 1D and a sixth step 502. The sixth step includes applying a carrier foil 506 to the back-grinded second major surface of the carrier 406. The carrier foil 506 may be the same length as the grinding foil 204.

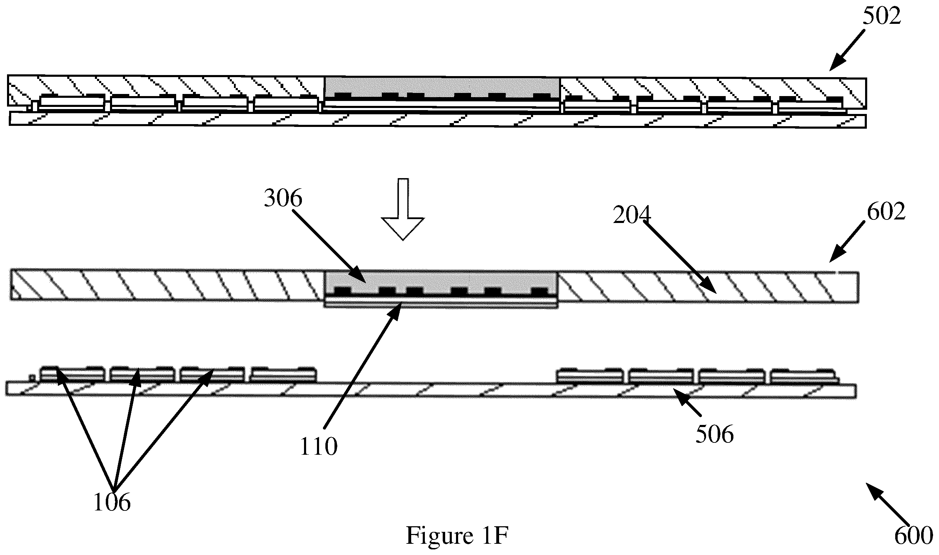

Figure 1F illustrates a sixth set of method steps 600 including the sixth step 502 of Figure 1E and a seventh step 602. The seventh step 602 includes separating the grinding foil 204 from the carrier foil 506. This separation releases the plurality of first semiconductor dies 106 onto the carrier foil 506 and the second semiconductor die 110 remains on the grinding foil 204. The second semiconductor die 110 remains on the grinding foil 204 because as mentioned previously, the grinding foil 204 has been modified to decrease the adhesive properties in the first region 118 of the grinding foil 204. The importance of separating the plurality of first semiconductor dies 106 onto the carrier foil 506 and the second semiconductor die 110 onto the grinding is as follows.

Usually die pick up processes for some applications, especially for very small die sizes require a wafer fully separated into die size areas, as non-separated areas might result in die shifts during pick up, flying dies. The caveat to this is that PCM's or in this case the second semiconductor die often exceed the typical die size for small integrated circuits. As a result, the second semiconductor die would need to be diced or removed to fit the die size area. This is a costly process as larger dies often include metal layers within them that cannot be diced when the rest of the wafer is diced as plasma dicing is very selective and cannot etch any metal layers. Laser grooving or pick and place tools could be used, but laser grooving is a very expensive process and pick and place tools can cause damage to wafer.

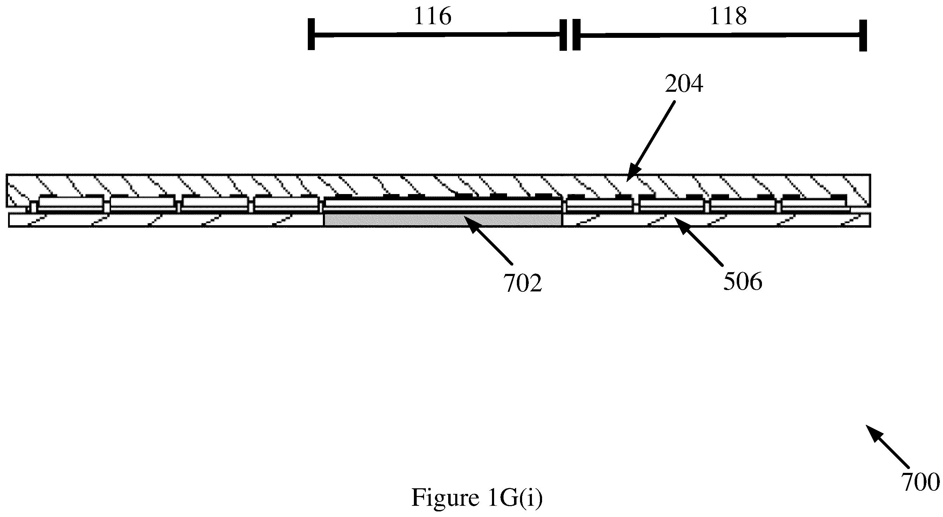

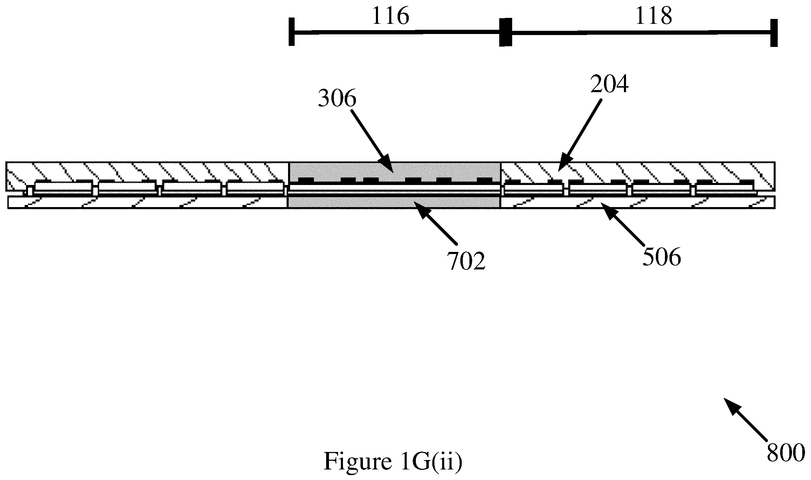

Figure 1G(i) illustrates an alternative modification step 700 that may include modifying the carrier foil 506 in a region 702 that is aligned with the second region 116. Modifying the carrier foil 506 in the region 702 may include illuminating the foil with UV light, as aforementioned. The carrier foil 506 in the first region 118 may be masked. Therefore, when the carrier foil 506 is illuminated with UV light, the first region 118 of the carrier foil 506 may not be illuminated with UV light. Therefore, the local adhesion of the carrier foil 506 in the first region 118 may be increased relative to the second region 116.

Figure 1G(ii) illustrates an alternative modification step 800 that may include modifying both the carrier foil 506 and the grinding foil 204. Modifying the carrier foil 506 and the grinding foil 204 may include illuminating both the carrier foil 506 and the grinding foil 204 with UV light, as mentioned previously.

From the foregoing description of the first embodiment, it will be clear that the inventive concept may be agnostic to the order in which some of the method steps are performed. For instance, the fourth step 302 including modifying the grinding foil 204 in the region 306 may be performed before or after the fifth step 402 including back grinding the second major surface of the carrier 108. Alternatively, the fourth step 302 including modifying the grinding foil 204 in the region 306 may be performed before or after the sixth step 502 including applying a carrier foil 506 to the back-grinded second major surface of the carrier 406.

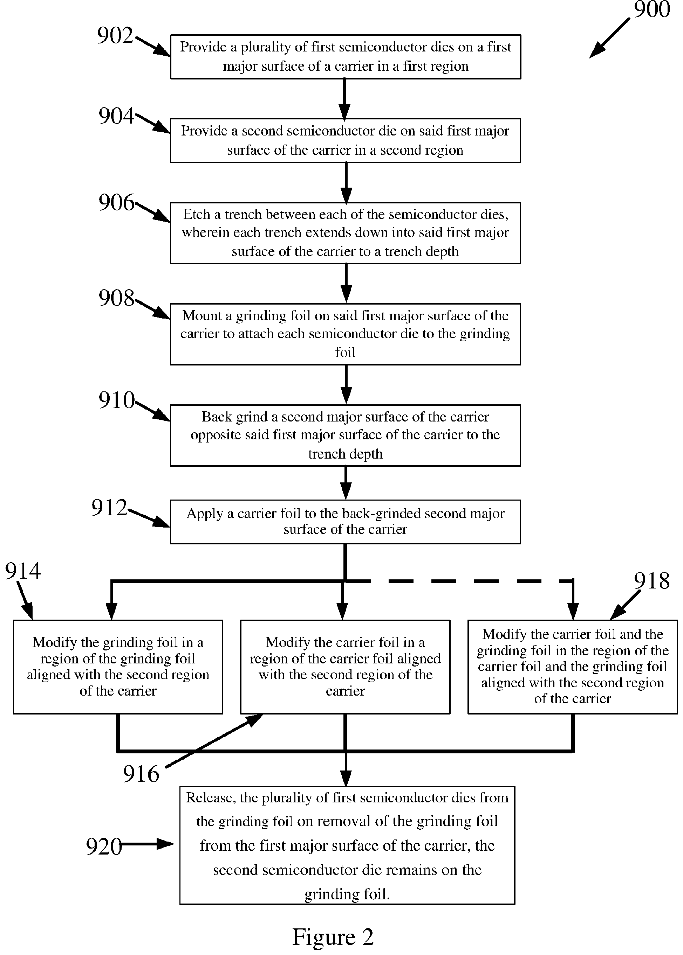

Figure 2 illustrates a flow diagram 900 including the method of the first embodiment. The first step 102 is encompassed by 902 and 904 and includes providing a plurality of first semiconductor dies and a second semiconductor die. The second step 104 is encompassed by 906 and includes etching a trench between each of the semiconductor dies. The third step 202 is encompassed by 908 and includes mounting a grinding foil onto the carrier. The fourth step 302 is encompassed by 910 and includes back grinding the carrier on an opposite surface to the third step 202/908. The fifth step 402 is encompassed by 912 and includes applying a carrier foil to the carrier. The sixth step 502 may include three different modification steps, as aforementioned. The user can either modify the grinding foil 914 or modify the carrier foil 916, or optionally the user may modify both the carrier foil and the grinding foil 918, as denoted by the dashed arrow. Lastly, the seventh step 602 is encompassed by 920 and includes releasing the plurality of first semiconductor dies from the grinding foil on removal of the grinding foil from the first major surface of the carrier and the second semiconductor die remains on the grinding foil.

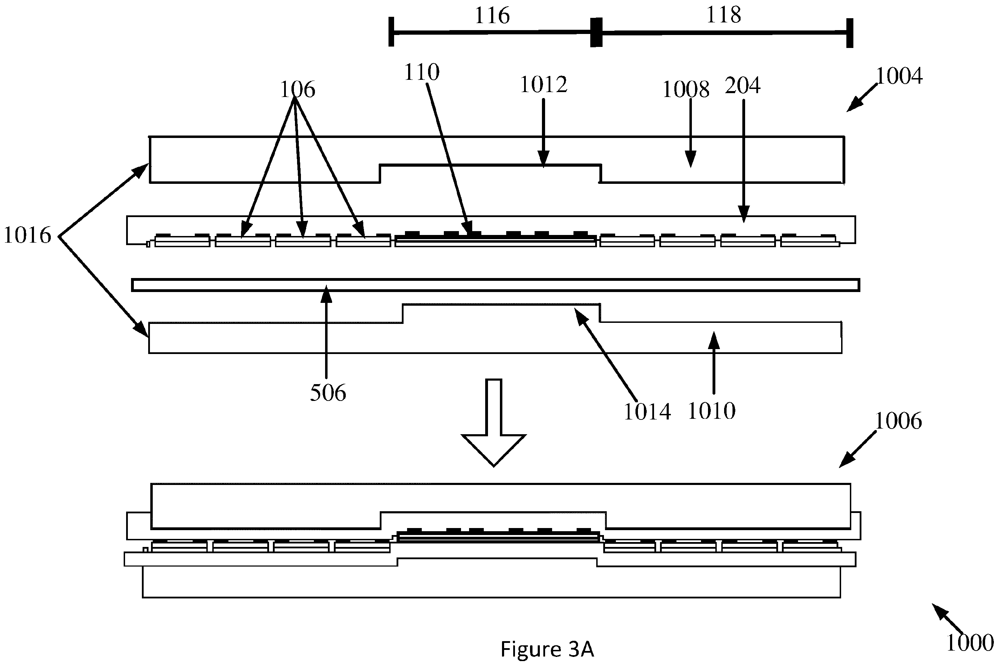

Figure 3A illustrates a first set of method steps 1000 including a first step 1004 and a second step 1006, in accordance with a second embodiment. The first step 1004 includes providing the plurality of semiconductor dies 106 and the second semiconductor die 110 which are attached to the grinding foil 204. The first step 1004 also includes providing the carrier foil 506. This step is similar to the fifth step 402 of the first embodiment.

The first step further provides a de-taping module that may include a template stamp 1016. The template stamp 1016 may include a first plate 1008 and a second plate 1010. The first plate 1008 may be located above the grinding foil 204 and may be aligned with the grinding foil 204. Conversely, the second plate 1010 may be located below the carrier foil 506 and may be aligned with the carrier foil 506. The first plate 1008 may include a debossed region 1012 that may be aligned with the second region 116. The second plate 1010 may include an embossed region 1014 that may be aligned with the second region 116. The debossed region 1012 of the first plate 1008 may be positioned directly opposite the embossed region 1014 of the second plate 1010.

As shown in Figure 3A, the first set of methods steps 1000 further includes the second step 1006, in accordance with the second embodiment. The second step 1006 includes using the de-taping module to bring the first plate 1008 and the second plate 1010 of the template stamp 1016 together. This results in pressing the carrier foil 506 to the back grinded surface of the plurality of semiconductor dies 106 and the second semiconductor die 110 which are attached to the grinding foil 204. The debossed region 1012 and the embossed region 1014 cause the de-taping module to apply increased pressure to the grinding foil 204 and the carrier foil 506 in the second region 116.

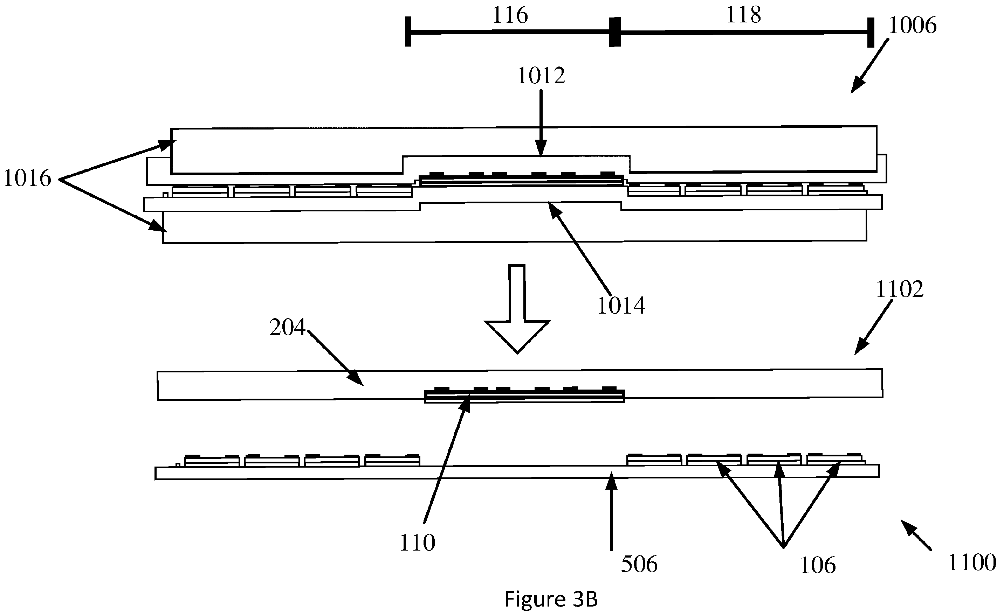

Figure 3B illustrates a second set of method steps 1100 including the second step 1006 of Figure 3A and a third step 1102. The third step 1102 includes releasing the grinding foil 204 and the carrier foil 506 from the template stamp 1016. The third step 1102 further includes releasing the plurality of first semiconductor dies 106 from the grinding foil 204 onto the carrier foil 506 and the second semiconductor die 110 remains on the grinding foil 204. This is a result of the increased pressure applied by the debossed region 1012 and the embossed region 1014 in the second region 116.

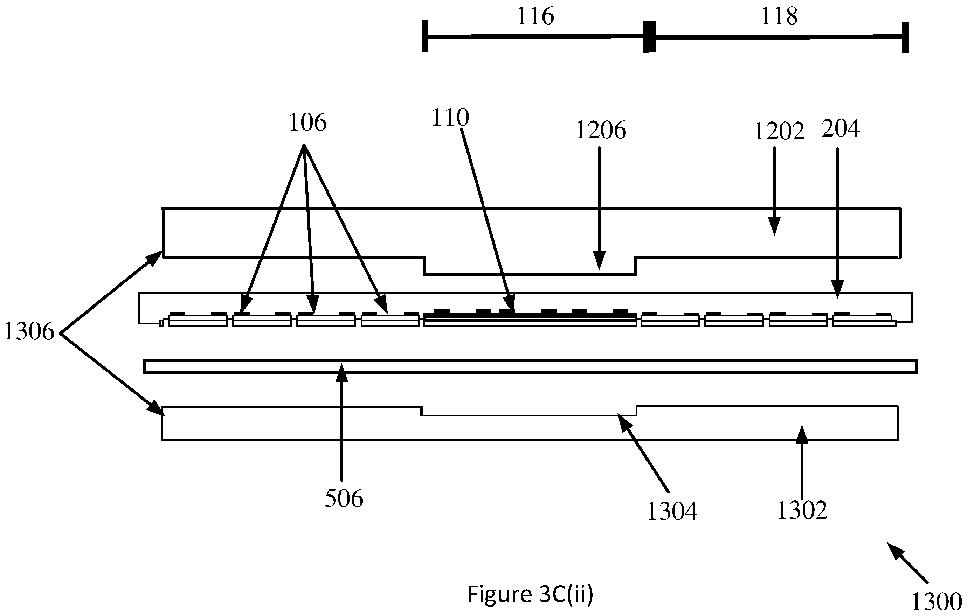

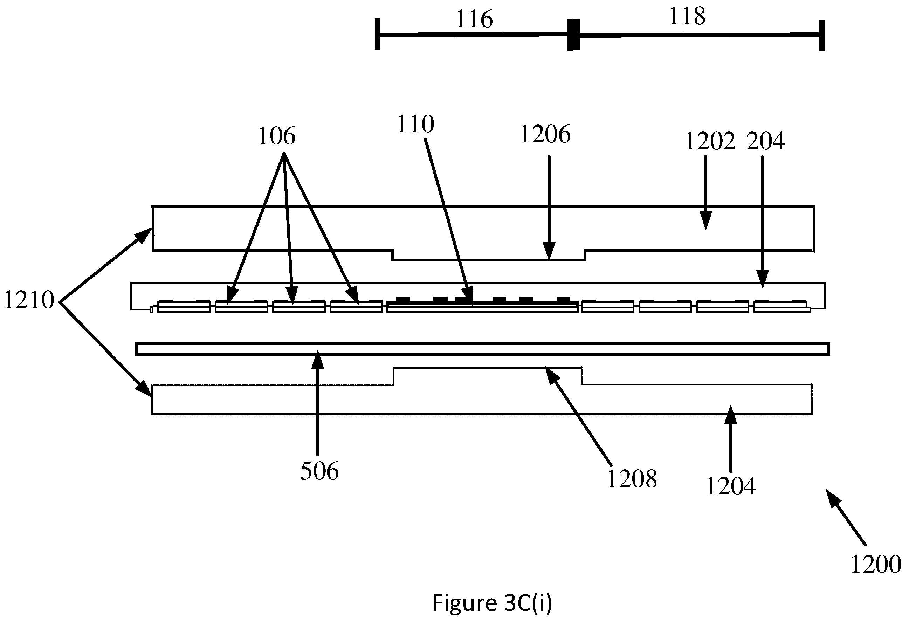

Figure 3C(i) illustrates an alternative de-taping module 1200 that may include a template stamp 1210. The template stamp 12 may include a first plate 1202 and a second plate 1204. The first plate 1202 may include an embossed region 1206 that may be aligned with the second region 116. The second plate 1204 may also include an embossed region 1208 that may be aligned with the second region 116. When the first plate 1202 and the second plate 1204 are brought together a similar effect is produced, as in Figure 3B. The embossed region 1206 of the first plate 1202 and the embossed region 1208 of the second plate 1204 cause the de-taping module 1200 to apply increased pressure to the grinding foil 204 and the carrier foil 506 in the second region 116.

Figure 3C(ii) illustrates an alternative de-taping module 1300 that may include a template stamp 1306. The template stamp 1306 may include a first plate 1202 and a second plate 1302. The first plate 1202 may include an embossed region 1206 that may be aligned with the second region 116. The second plate 1302 may include a debossed region 1304 that may be aligned with the second region 116. When the first plate 1202 and the second plate 1302 are brought together a similar effect is produced, as in Figure 3B. the embossed region 1206 of the first plate 1202 and the debossed region 1304 of the second plate 1302 cause the de-taping module 1300 to apply increased pressure to the grinding foil 204 and the carrier foil 506 in the second region 116.

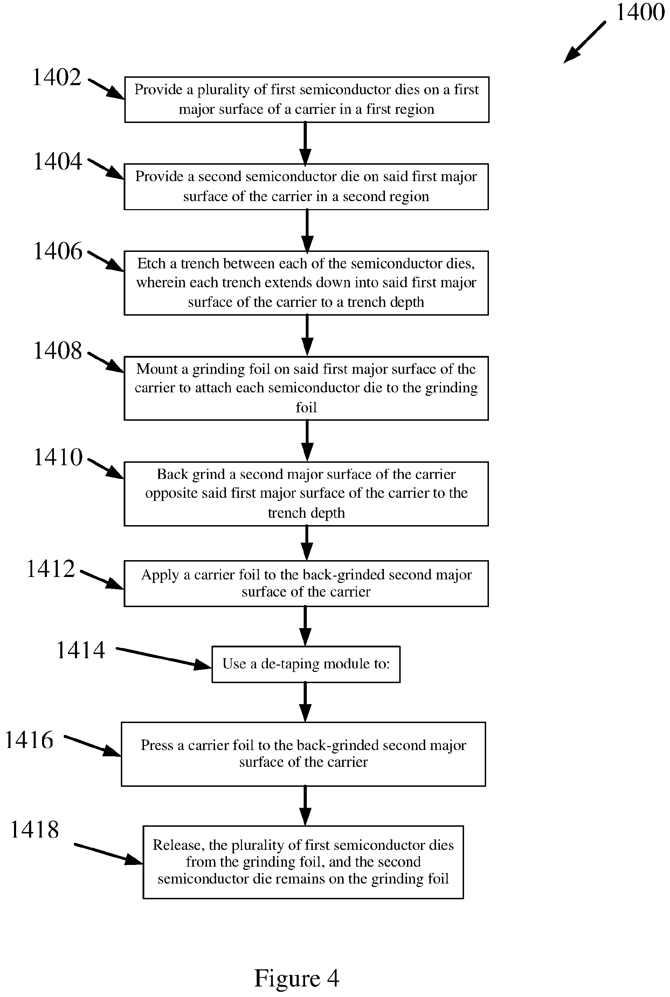

Figure 4 illustrates a flow diagram 1400 including the method of the second embodiment. The first step 1004 of Figure 3A is encompassed by 1402 to 1412 and includes providing a plurality of first semiconductor dies and a second semiconductor die that are attached to the grinding foil and providing the carrier foil. The second step 1006 is encompassed by 1414 and 1416 and includes using the de-taping module to press the carrier foil to the grinding foil and the plurality of first semiconductor dies and the second semiconductor die. The third step 1102 of Figure 3B is encompassed by 1418 and includes the release of the plurality of first semiconductor dies from the grinding foil and the second semiconductor die remains on the grinding foil.

Accordingly, there has been described a method including, providing a plurality of first semiconductor dies on a first surface of a carrier in a first region. Providing a second semiconductor die on the carrier in a second region. Etching a trench between each of the semiconductor dies, each trench extends down into the carrier to a trench depth. Mounting a grinding foil on the carrier to attach each semiconductor die to the grinding foil. Back grinding a second surface of the carrier to the trench depth. Applying a carrier foil to the back-grinded second surface of the carrier. Either modifying the grinding foil or the carrier foil in a region aligned with the second region or use a de-taping module to press the grinding foil to the carrier foil. Then releasing, the plurality of first semiconductor dies from the grinding foil. The modification causes the second semiconductor die to remain on the grinding foil.

Although particular embodiments of the present disclosure have been described, it will be appreciated that many modifications/additions and/or substitutions may be made within the scope of the claimed disclosure.

## Claims

1. A method, comprising:
providing a plurality of first semiconductor dies on a first major surface of a carrier in a first region;
providing a second semiconductor die on said first major surface of the carrier in a second region;
etching a trench between each of the semiconductor dies, wherein each trench extends down into said first major surface of the carrier to a trench depth;
mounting a grinding foil on said first major surface of the carrier to attach each semiconductor die to the grinding foil;
back grinding a second major surface of the carrier opposite said first major surface of the carrier at least to the trench depth;
applying a carrier foil to the back-grinded second major surface of the carrier; and
either:
modifying the grinding foil in a region of the grinding foil aligned with the first region of the carrier;
or
modifying the carrier foil in a region of the carrier foil aligned with the first region of the carrier;
wherein said modification of the grinding foil or the carrier foil causes the plurality of first semiconductor dies to release from the grinding foil on removal of the grinding foil from the first major surface of the carrier, wherein the second semiconductor die remains on the grinding foil.

2. The method of claim 1, wherein the method further comprises modifying both the carrier foil and the grinding foil aligned with the first region of the carrier.

3. The method of claim 1 or claim 2, wherein the modifying step is configured to:
locally decrease the adhesion of the grinding foil in the first region of the carrier, and/or
locally increase the adhesion of the carrier foil in the first region of the carrier.

4. The method of claim 3, wherein the modifying step comprises, illuminating a foil in the first region, wherein the foil is illuminated with UV light that ranges from 100nm to 400nm.

5. The method of claim 4, comprising using a mask during said illumination of the foil in the first region to mask the second region from the UV light.

6. The method of claim 3, wherein the modifying step comprises, applying an additional adhesion layer to the foil, wherein the additional adhesion layer comprises an adhesion promoting or inhibiting material.

7. The method of claim 3, wherein the modifying step comprises, applying a local surface treatment using a laser.

8. The method of claim 3, wherein the modifying step further comprises, modifying a major surface of the second semiconductor die, wherein the modification comprises a dedicated bump structure for increasing the surface area of the major surface, or a local topography modification, to increase the adhesion of the grinding foil to the second semiconductor die.

9. The method of any preceding claim, wherein the second semiconductor die comprises a process control monitor, PCM.

10. A method, comprising:
providing a plurality of first semiconductor dies on a first major surface of a carrier in a first region;
providing a second semiconductor die on said first major surface of the carrier in a second region;
etching a trench between each of the semiconductor dies, wherein each trench extends down into said first major surface of the carrier to a trench depth;
mounting a grinding foil on said first major surface of the carrier to attach each semiconductor die to the grinding foil;
back grinding a second major surface of the carrier opposite said first major surface of the carrier at least to the trench depth;
using a de-taping module to press a carrier foil to the back-grinded second major surface of the carrier; and
removing the grinding foil from the first major surface of the carrier, to release the plurality of first semiconductor dies from the grinding foil,
wherein said de-taping module applies pressure to the grinding foil in said second region of the carrier to cause the second semiconductor die to remain on the grinding foil on removal of the grinding foil from the first major surface of the carrier.

11. The method of claim 10, wherein the de-taping module comprises a template stamp to apply pressure to the carrier foil and the grinding foil.

12. The method of claim 11, wherein the template stamp comprises a shape that corresponds to the second region, wherein the shape of the template stamp has a topography to increase the pressure in the second region.

13. The method of claim 12, wherein the topography of the template stamp comprises an embossed part and a corresponding debossed part, located opposite the embossed part.

14. The method of claim 12, wherein the topography of the template stamp comprises two mutually opposed embossed parts.

15. The method of any of claims 10 to 14, wherein the second semiconductor die is a process control monitor, PCM.
